# EUROPEAN PATENT APPLICATION

(11) **EP 4 572 146 A1**
(43) Date of publication of application: **18.06.2025**
(21) Application number: 24210029.5
(22) Date of filing: 31.10.2024
(51) Int. Cl.: H03K 19/0185, H03K 19/17736, G06F 13/40, G06F 13/42

(54) **TECHNIQUES FOR CONFIGURING REPEATER CIRCUITS IN ACTIVE INTERCONNECTION DEVICES**

(30) Priority: 12.12.2023 US 202318537571
(71) Applicant: Altera Corporation, San Jose, CA 95134 (US)
(72) Inventor: Kumashikar, Mahesh, 560066 Bangalore KA (IN); Maheshwari, Atul, Portland OR, 97229 (US); Hossain, MD Altaf, Portland OR, 97229 (US); Nalamalpu, Ankireddy, Portland OR, 97229 (US); Kolluru, Krishna Bharath, Hillsboro OR, 97124 (US)
(74) Representative: Samson & Partner Patentanwälte mbB

(57) **Abstract**

An active interconnection device has a repeater circuit that includes a storage circuit. The storage circuit is coupled to store a configuration bit for configuring the repeater circuit to transmit a signal between a first integrated circuit die and a second integrated circuit die. The storage circuit is coupled to receive the configuration bit through a conductor during a configuration mode. A buffer circuit in the repeater circuit is configurable to transmit the signal through the conductor during a transmission mode in response to the configuration bit.

## Description

### TECHNICAL FIELD

The present disclosure relates to electronic integrated circuits, and more particularly, to techniques for configuring repeater circuits in active interconnection devices.

### BACKGROUND

Configurable integrated circuits (ICs) can be configured by users to implement desired custom logic functions. In a typical scenario, a logic designer uses computer-aided design (CAD) tools to design a custom circuit design. When the design process is complete, the computer-aided design tools generate configuration data. The configuration data is then loaded into configuration memory elements that configure configurable logic circuits in the integrated circuit to perform the functions of the custom circuit design.

### BRIEF DESCRIPTION OF DRAWINGS

Figure 1 is a diagram that illustrates an example of a circuit system that includes an active interconnection device and two integrated circuit dies.
Figure 2 is a diagram that illustrates an example of a configurable logic integrated circuit that can implement techniques disclosed herein.
Figure 3 is a block diagram of a system that can be used to implement a circuit design to be programmed onto a programmable logic device using design software.
Figure 4 is a diagram that depicts an example of a programmable logic device that includes a fabric die and a base die that are connected to one another via microbumps.
Figure 5 is a block diagram illustrating a computing system configured to implement one or more aspects of the embodiments disclosed herein.

### DETAILED DESCRIPTION

In many types of integrated circuit systems, bridges or interposers are used to enable disaggregation of integrated circuit (IC) dies (e.g., configurable ICs) using three-dimensional stacking techniques. Disaggregation of IC dies with high wire density is important in a high performance computing system-on-chip (SoC). There are two primary technology options for bridges and interposers.

One option is a passive silicon bridge or interposer having interconnect that travels between IC dies without any repeater circuits or other active circuits. Die disaggregation of a field programmable gate array (FPGA) can be implemented by die-to-die (D2D) interconnect between two programmable fabric dies. One unique aspect of D2D interconnect of FPGA fabric dies is that the direction of each interconnect is set during compile time. If IC dies are connected by a passive interposer or bridge, configuration data can be used to configure circuitry in the IC dies to be drivers or receivers for transmission through the passive interposer or bridge.

Active bridges and interposers have interconnect and repeater circuits to enable long-distance, low-power die-to-die interconnect. The disaggregation of an FPGA imposes a unique constraint that the interconnect can be configured to be a driver or a receiver during design configuration. With an active bridge or interposer, repeaters in the bridge or interposer also have to be configured during compile time of the design configuration. In active bridges or interposers, silicon wires having a finer pitch than the wires used in passive bridges or interposers can be used to connect IC dies, because the wires can be repeated on the active bridge or interposer. This capability allows for much higher wire density and lower power for a given wire density.

The primary problem of using an active bridge or interposer for FPGA die disaggregation is to build the capability to set the direction of the wires during software compile time. The repeaters in the active bridge or interposer are designed to be configured to be driver or receiver repeaters. Each of the configuration bits is sent through a separate wire to the bridge or interposer. Thus, there is one configuration wire for each fabric wire (i.e., one-to-one overhead), which causes a 100% increase in wire count to the bridge or interposer. The extra wires cause lower effective wire density for a given bridge or interposer dimension and higher power consumption to transmit configuration bits through the extra wires. Active bridges and interposers are also referred to herein as active interconnection devices.

According to some examples disclosed herein, an active interconnection device is provided that has repeater circuits and storage circuits. During configuration of the active interconnection device, configuration bits are transmitted to the active interconnection device through the same wires that are used to transmit other signals, such as data and clock signals, through the active configuration device during a transmission mode. The configuration bits are stored in the storage circuits and subsequently used to configure the repeater circuits to drive signals in one of two different directions during the transmission mode. The active interconnection device has a reduced number of wires for configuring the repeater circuits compared to previously known techniques.

One or more specific examples are described below. In an effort to provide a concise description of these examples, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Throughout the specification, and in the claims, the term "connected" means a direct electrical connection between the circuits that are connected, without any intermediary devices. The term "coupled" means either a direct electrical connection between circuits or an indirect electrical connection through one or more passive or active intermediary devices that allows the transfer of information between circuits. The term "circuit" may mean one or more passive and/or active electrical components that are arranged to cooperate with one another to provide a desired function.

This disclosure discusses integrated circuit devices, including configurable (programmable) logic integrated circuits, such as field programmable gate arrays (FPGAs). As discussed herein, an integrated circuit (IC) can include hard logic and/or soft logic. The circuits in an integrated circuit device (e.g., in a configurable logic IC) that are configurable by an end user are referred to as "soft logic." "Hard logic" generally refers to circuits in an integrated circuit device that have substantially less configurable features than soft logic or no configurable features.

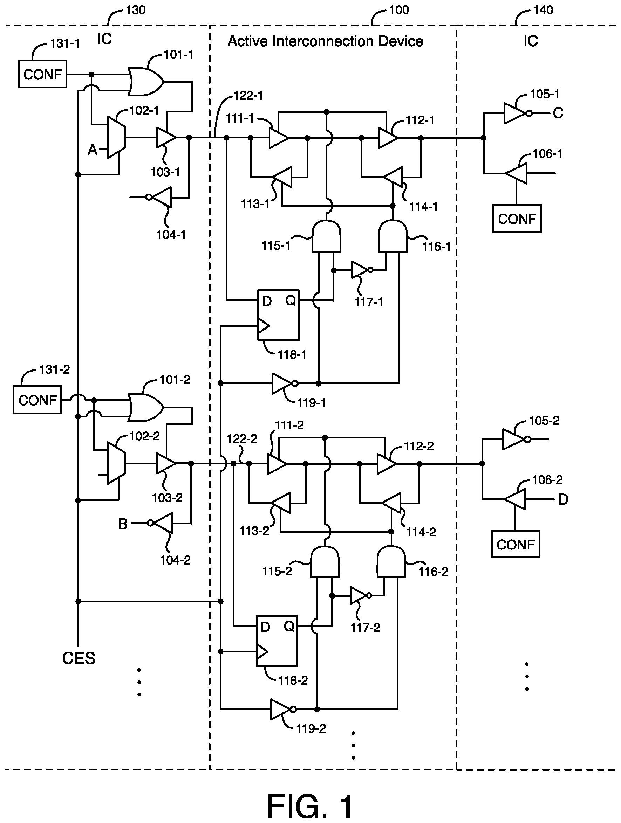

Figure 1 is a diagram that illustrates an example of a circuit system that includes an active interconnection device 100 and two integrated circuit (IC) dies 130 and 140. IC dies 130 and 140 are also referred to herein as integrated circuits (ICs) 130 and 140. ICs 130 and 140 can be any type of ICs, such as configurable ICs (e.g., field programmable gate arrays (FPGAs) or programmable logic devices), microprocessor ICs, graphics processing unit ICs, memory ICs, application specific ICs, transceiver ICs, memory ICs, or any combination thereof. FIG. 1 shows a top down view of the circuit system. Active interconnection device 100 is an active interposer, an active bridge, or any other die-to-die interconnection device that contains conductors (also referred to as wires) and active circuits (e.g., transistors).

The active interconnection device 100 couples IC 130 and IC 140 together in the circuit system of FIG. 1. Although FIG. 1 shows active interconnection device 100 coupling two ICs together, in other implementations, active interconnection device 100 can couple any number of ICs together. Active interconnection device 100 may also be referred to as an active connection device.

IC 130 includes OR gate circuits 101-1 and 101-2, multiplexer circuits 102-1 and 102-2, output buffer circuits 103-1 and 103-2, inverting input buffer circuits 104-1 and 104-2, and configuration (CONF) storage circuits 131-1 and 131-2, which are collectively referred to herein as OR gate circuits 101, multiplexer circuits 102, output buffer circuits 103, input buffer circuits 104, and configuration storage circuits 131, respectively. IC 140 includes inverting input buffer circuits 105-1 and 105-2 and output buffer circuits 106-1 and 106-2, which are collectively referred to herein as input buffer circuits 105 and output buffer circuits 106, respectively.

Active interconnection device 100 includes conductors 122-1, 122-2, etc. (collectively referred to as conductors 122) and two or more repeater circuits. Two repeater circuits are shown in FIG. 1 as an example. Although, active interconnection device 100 can have any number of repeater circuits. The first repeater circuit shown in FIG. 1 includes buffer circuits 111-1, 112-1, 113-1, and 114-1, AND gate circuits 115-1 and 116-1, inverter circuits 117-1 and 119-1, and D flip-flop storage circuit 118-1. The second repeater circuit shown in FIG. 1 includes buffer circuits 111-2, 112-2, 113-2, and 114-2, AND gate circuits 115-2 and 116-2, inverter circuits 117-2 and 119-2, and D flip-flop storage circuit 118-2.

Buffer circuits 111-1 and 111-2, buffer circuits 112-1 and 112-2, buffer circuits 113-1 and 113-2, and buffer circuits 114-1 and 114-2 are collectively referred to herein as buffer circuits 111, buffer circuits 112, buffer circuits 113, and buffer circuits 114, respectively. The AND gate circuits 115-1 and 115-2, AND gate circuits 116-1 and 116-2, inverter circuits 117-1 and 117-2, D flip-flop storage circuits 118-1 and 118-2, and inverter circuits 119-1 and 119-2 are collectively referred to herein as AND gate circuits 115, AND gate circuits 116, inverter circuits 117, flip-flop storage circuits 118, and inverter circuits 119, respectively.

During a configuration mode of the repeater circuits in the active interconnection device 100, configuration bits are transmitted from configuration storage circuits 131 in IC 130 to storage circuits 118 in the active interconnection device 100 through the same conductors 122 that are used to transmit other signals (e.g., data and clock signals) through the active configuration device 100 during a transmission mode. Because the same conductors 122 are shared during configuration and transmission modes, active interconnection device 100 has a reduced number of conductors for configuring the repeater circuits compared to previously known techniques. Using active interconnection device 100 to connect together two IC dies 130 and 140 also reduces the number of conductive bumps that are used to connect IC dies 130 and 140 to active interconnection device 100. Thus, active interconnection device 100 increases wire density and reduces the circuit area, power consumption, and cost compared to previously known techniques.

The configuration of the repeater circuits in the active interconnection device 100 is now described in further detail. During the configuration mode, a configuration enable signal CES is asserted to a logic high state to enable the configuration of the repeater circuits in the active interconnection device 100. The configuration enable signal CES is provided to an input of each of the OR gate circuits 101, a select input of each of multiplexer circuits 102, a clock input of each of flip-flop storage circuits 118, and an input of each of inverter circuits 119. In response to configuration enable signal CES being in a logic high state, OR gate circuits 101 enable buffer circuits 103, and multiplexer circuits 102 are configured to provide the values of configuration bits from configuration storage circuits 131 to inputs of buffer circuits 103. Buffer circuits 103 buffer the values of the configuration bits, and then the values of the configuration bits are provided through conductors 122 to the D inputs of flip-flop storage circuits 118.

Also, in response to configuration enable signal CES being in a logic high state, the inverter circuits 119 generate output signals having logic low states. In response to the logic low state in the output signal of each inverter circuit 119, the respective AND gate circuit 115 provides a signal in a logic low state to the enable inputs of buffer circuits 111 and 112, and the respective AND gate circuit 116 provides a signal in a logic low state to the enable inputs of buffer circuits 113 and 114. As a result, buffer circuits 111-114 are disabled during the configuration mode.

Also, in response to configuration enable signal CES being in a logic high state, flip-flop storage circuits 118 are enabled to store the values of the configuration bits. Upon receiving the values of the configuration bits from buffer circuits 103 through conductors 122, the values of the configuration bits are stored in the storage circuits 118 at their respective Q outputs. While the CES signal is in a logic high state, the values of the configuration bits stored in the storage circuits 118 do not affect whether the buffer circuits 111-114 are enabled or disabled.

After the configuration mode, the active interconnection device 100 is operated in the transmission mode. The values of the configuration bits stored in storage circuits 118 are used to configure each repeater circuit (specifically each set of buffer circuits 111-114) to transmit signals in one of two directions between ICs 130 and 140 during the transmission mode. The two directions are from IC 130 to IC 140 and from IC 140 to IC 130 in FIG. 1. Configuring a set of buffer circuits 111-114 to transmit signals in either of these two directions can also be considered to be configuring the respective buffer circuits 111-114 as transmitters or receivers.

During the transmission mode, the configuration enable signal CES is de-asserted to a logic low state. In response to signal CES being in a logic low state, flip-flop circuits 118 do not store additional values output by the buffer circuits 103, and the output signals of inverter circuits 119 are in logic high states. In response to the logic high state in the output signal of each inverter circuit 119, the respective AND gate circuit 115 provides the output signal of the respective flip-flop storage circuit 118 to enable inputs of the respective buffer circuits 111 and 112. Also, in response to the logic high state in the output signal of each inverter circuit 119, the respective AND gate circuit 116 provides an inverted version of the output signal of the respective flip-flop storage circuit 118 generated by the respective inverter circuit 117 to enable inputs of the respective buffer circuits 113 and 114. As a result, the buffer circuits 111-114 are configured to be enabled or disabled in response to the values of the configuration bits stored in the flip-flop storage circuits 118.

Also, in response to signal CES being in a logic low state during transmission mode, multiplexer circuits 102 provide signals at their second data inputs (e.g., signal A) to buffer circuits 103, and configuration storage circuits 131 enable or disable buffer circuits 103 by providing the values of configuration bits through OR gates 101. The active interconnection device 100 can then be used to transmit signals (e.g., data, control, or clock signals) between ICs 130 and 140 through conductors 122 in the transmission mode. Each of the repeater circuits in active interconnection device 100 can be independently configured during transmission mode by the value of the configuration bit stored in the respective storage circuit 118 to transmit signals in one of the two directions from IC 130 to IC 140 or from IC 140 to IC 130.

As an example, the first repeater circuit in the active interconnection device 100 can be configured to transmit the value of signal A from IC 130 to signal C in IC 140 during the transmission mode. In this example, the buffer circuits 113-1 and 114-1 are disabled, and the buffer circuits 111-1 and 112-1 are enabled during the transmission mode to transmit the value of signal A as received through multiplexer circuit 102-1, buffer circuit 103-1, and conductor 122-1 to buffer circuit 105-1 for transmission to other circuitry in IC 140 as signal C.

As another example, the second repeater circuit in the active interconnection device 100 can be configured to transmit the value of signal D from IC 140 to signal B in IC 130 during the transmission mode. In this example, the buffer circuits 111-2 and 112-2 are disabled, and the buffer circuits 113-2 and 114-2 are enabled during the transmission mode to transmit the value of signal D as received through buffer circuit 106-2 through conductor 122-2 to buffer circuit 104-2 for transmission to other circuitry in IC 130 as signal B.

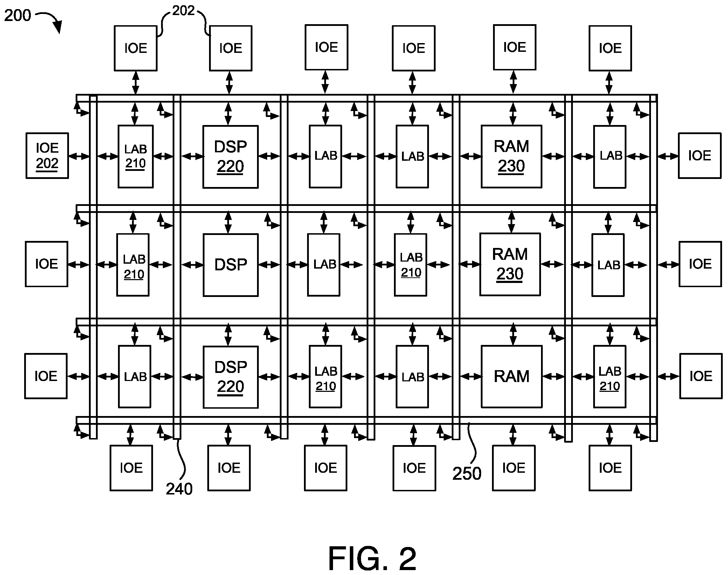

Figure (FIG.) 2 is a diagram that illustrates an example of a configurable logic IC 200 that can implement techniques disclosed herein. ICs 130 and/or 140 disclosed herein can include the architecture of configurable logic IC 200 according to some examples. As shown in FIG. 2, the configurable logic IC 200 includes a two-dimensional array of configurable functional circuit blocks, including configurable logic array blocks (LABs) 210 and other functional circuit blocks, such as random access memory (RAM) blocks 230 and digital signal processing (DSP) blocks 220. Functional blocks such as LABs 210 can include smaller programmable logic circuits (e.g., logic elements, logic blocks, or adaptive logic modules) that receive input signals and perform custom functions on the input signals to produce output signals.

In addition, configurable logic IC 200 can have input/output elements (IOEs) 202 for driving signals off of configurable logic IC 200 and for receiving signals from other devices. IOEs 202 may include parallel input/output circuitry, serial data transceiver circuitry, differential receiver and transmitter circuitry, or other circuitry used to connect one integrated circuit to another integrated circuit. As shown, IOEs 202 may be located around the periphery of the chip. If desired, the configurable logic IC 200 may have IOEs 202 arranged in different ways. For example, IOEs 202 may form one or more columns, rows, or islands of input/output elements that may be located anywhere on the configurable IC 200. Input/output elements 202 can include general purpose input/output (GPIO) circuitry (e.g., on the top and bottoms edges of IC 200), high-speed input/output (HSIO) circuitry (e.g., on the left edge of IC 200), and on-package input/output (OPIOs) circuitry (e.g., on the right edge of IC 200).

The configurable logic IC 200 can also include programmable interconnect circuitry in the form of vertical routing channels 240 (i.e., interconnects formed along a vertical axis of configurable logic IC 200) and horizontal routing channels 250 (i.e., interconnects formed along a horizontal axis of configurable logic IC 200), each routing channel including at least one track to route at least one wire. One or more of the routing channels 240 and/or 250 can be part of a network-on-chip (NOC) having router circuits.

Note that other routing topologies, besides the topology of the interconnect circuitry depicted in FIG. 2, can be used. For example, the routing topology may include wires that travel diagonally or that travel horizontally and vertically along different parts of their extent as well as wires that are perpendicular to the device plane in the case of three dimensional integrated circuits. The driver of a wire may be located at a different point than one end of a wire.

Furthermore, it should be understood that embodiments disclosed herein with respect to FIG. 1 can be implemented in any integrated circuit or electronic system. If desired, the functional blocks of such an integrated circuit can be arranged in more levels or layers in which multiple functional blocks are interconnected to form still larger blocks. Other device arrangements can use functional blocks that are not arranged in rows and columns.

Configurable logic IC 200 can contain programmable memory elements. Memory elements can be loaded with configuration data using IOEs 202. Once loaded, the memory elements each provide a corresponding static control signal that controls the operation of an associated configurable functional block (e.g., LABs 210, DSP blocks 220, RAM blocks 230, or IOEs 202). The configuration data can set the functions of the configurable functional circuit blocks (soft logic) in IC 200.

In a typical scenario, the outputs of the loaded memory elements are applied to the gates of field-effect transistors in a functional block to turn certain transistors on or off and thereby configure the logic in the functional block including the routing paths. Programmable logic circuit elements that are controlled in this way include parts of multiplexers (e.g., multiplexers used for forming routing paths in interconnect circuits), look-up tables, logic arrays, AND, OR, NAND, and NOR logic gates, pass gates, etc.

The memory elements can use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory or programmable memory elements.

The memory elements can be organized in a configuration memory array consisting of rows and columns. A data register that spans across all columns and an address register that spans across all rows may receive configuration data. The configuration data can be shifted onto the data register. When the appropriate address register is asserted, the data register writes the configuration data to the configuration memory bits of the row that was designated by the address register.

Configurable integrated circuit 200 can include configuration memory that is organized in sectors, whereby a sector can include the configuration bits that specify the function and/or interconnections of the subcomponents and wires in or crossing that sector. Each sector can include separate data and address registers.

The configurable IC of FIG. 2 is merely one example of an IC that can include embodiments disclosed herein. The embodiments disclosed herein may be incorporated into any suitable integrated circuit or system. For example, the embodiments disclosed herein can be incorporated into numerous types of devices such as processor integrated circuits, central processing units, memory integrated circuits, graphics processing unit integrated circuits, application specific standard products (ASSPs), application specific integrated circuits (ASICs), and programmable logic integrated circuits. Examples of programmable logic integrated circuits include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The integrated circuits disclosed in one or more embodiments herein may be part of a data processing system that includes one or more of the following components: a processor; memory; input/output circuitry; and peripheral devices. The data processing system can be used in a wide variety of applications, such as computer networking, data networking, instrumentation, video processing, digital signal processing, or any suitable other application. The integrated circuits can be used to perform a variety of different logic functions.

In general, software and data for performing any of the functions disclosed herein can be stored in non-transitory computer readable storage media. Non-transitory computer readable storage media is tangible computer readable storage media that stores data and software for access at a later time, as opposed to media that only transmits propagating electrical signals (e.g., wires). The software code may sometimes be referred to as software, data, program instructions, instructions, or code. The non-transitory computer readable storage media can, for example, include computer memory chips, non-volatile memory such as non-volatile random-access memory (NVRAM), one or more hard drives (e.g., magnetic drives or solid state drives), one or more removable flash drives or other removable media, compact discs (CDs), digital versatile discs (DVDs), Blu-ray discs (BDs), other optical media, and floppy diskettes, tapes, or any other suitable memory or storage device(s).

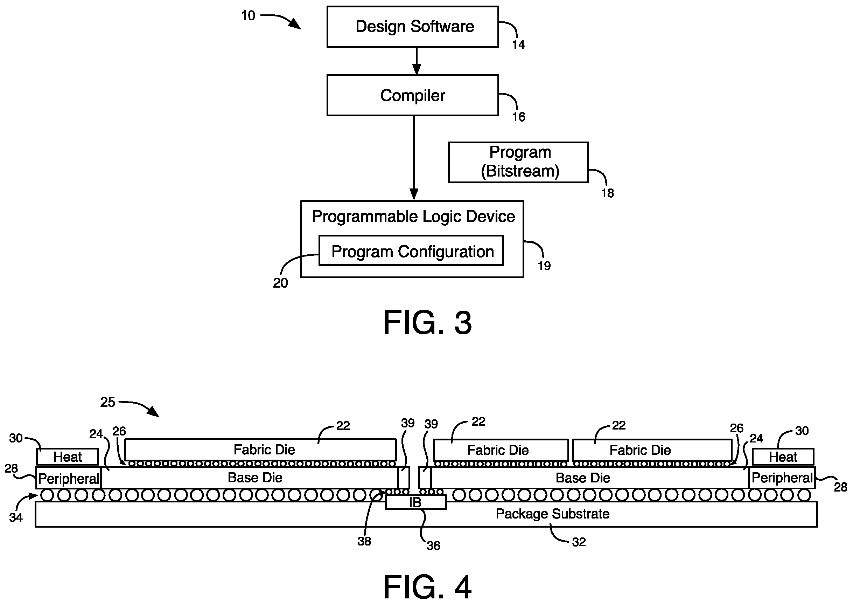

Figure 3 illustrates a block diagram of a system 10 that can be used to implement a circuit design to be programmed onto a programmable logic device 19 using design software. A designer can implement circuit design functionality on an integrated circuit, such as a reconfigurable programmable logic device 19 (e.g., a field programmable gate array (FPGA)). The designer can implement the circuit design to be programmed onto the programmable logic device 19 using design software 14. The design software 14 can use a compiler 16 to generate a low-level circuit-design program (bitstream) 18, sometimes known as a program object file and/or configuration program, that programs the programmable logic device 19. Thus, the compiler 16 can provide machine-readable instructions representative of the circuit design to the programmable logic device 19. For example, the programmable logic device 19 can receive one or more programs (bitstreams) 18 that describe the hardware implementations that should be stored in the programmable logic device 19. A program (bitstream) 18 can be programmed into the programmable logic device 19 as a configuration program 20. The configuration program 20 can, in some cases, represent an accelerator function to perform for machine learning, video processing, voice recognition, image recognition, or other highly specialized tasks.

In some implementations, a programmable logic device can be any integrated circuit device that includes a programmable logic device with two separate integrated circuit die where at least some of the programmable logic fabric is separated from at least some of the fabric support circuitry that operates the programmable logic fabric. One example of such a programmable logic device is shown in FIG. 4, but many others can be used, and it should be understood that this disclosure is intended to encompass any suitable programmable logic device where programmable logic fabric and fabric support circuitry are at least partially separated on different integrated circuit die.

Figure 4 is a diagram that depicts an example of the programmable logic device 25 that includes three fabric die 22 and two base die 24 that are connected to one another via microbumps 26. In the example of FIG. 4, at least some of the programmable logic fabric of the programmable logic device 25 is in the three fabric die 22, and at least some of the fabric support circuitry that operates the programmable logic fabric is in the two base die 24. For example, some of the circuitry of configurable IC 200 shown in FIG. 2 (e.g., LABs 210, DSP 220, RAM 230) can be located in the fabric die 22 and some of the circuitry of IC 200 (e.g., input/output elements 202) can be located in the base die 24.

Although the fabric die 22 and base die 24 appear in a one-to-one relationship or a two-to-one relationship in FIG. 4, other relationships can be used. For example, a single base die 24 can attach to several fabric die 22, or several base die 24 can attach to a single fabric die 22, or several base die 24 can attach to several fabric die 22 (e.g., in an interleaved pattern). Peripheral circuitry 28 can be attached to, embedded within, and/or disposed on top of the base die 24, and heat spreaders 30 can be used to reduce an accumulation of heat on the programmable logic device 25. The heat spreaders 30 can appear above, as pictured, and/or below the package (e.g., as a double-sided heat sink). The base die 24 can attach to a package substrate 32 via conductive bumps 34. In the example of FIG. 4, two pairs of fabric die 22 and base die 24 are shown communicatively connected to one another via an interconnect bridge 36 (e.g., an embedded multi-die interconnect bridge (EMIB)) and microbumps 38 at bridge interfaces 39 in base die 24.

In combination, the fabric die 22 and the base die 24 can operate in combination as a programmable logic device 25 such as a field programmable gate array (FPGA). It should be understood that an FPGA can, for example, represent the type of circuitry, and/or a logical arrangement, of a programmable logic device when both the fabric die 22 and the base die 24 operate in combination. Moreover, an FPGA is discussed herein for the purposes of this example, though it should be understood that any suitable type of programmable logic device can be used.

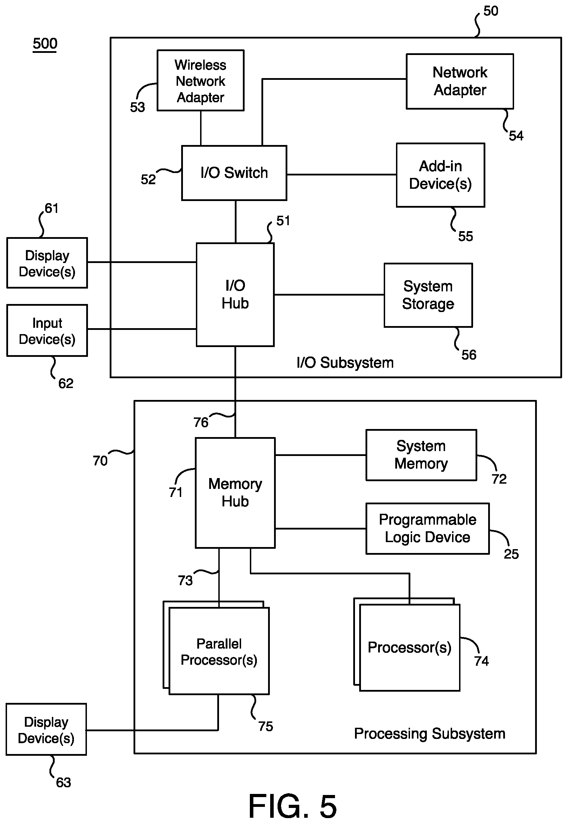

Figure 5 is a block diagram illustrating a computing system 500 configured to implement one or more aspects of the embodiments described herein. The computing system 500 includes a processing subsystem 70 having one or more processor(s) 74, a system memory 72, and a programmable logic device 25 communicating via an interconnection path that can include a memory hub 71. The memory hub 71 can be a separate component within a chipset component or can be integrated within the one or more processor(s) 74. The memory hub 71 couples with an input/output (I/O) subsystem 50 via a communication link 76. The I/O subsystem 50 includes an input/output (I/O) hub 51 that can enable the computing system 500 to receive input from one or more input device(s) 62. Additionally, the I/O hub 51 can enable a display controller, which can be included in the one or more processor(s) 74, to provide outputs to one or more display device(s) 61. In one embodiment, the one or more display device(s) 61 coupled with the I/O hub 51 can include a local, internal, or embedded display device.

In one embodiment, the processing subsystem 70 includes one or more parallel processor(s) 75 coupled to memory hub 71 via a bus or other communication link 73. The communication link 73 can use one of any number of standards based communication link technologies or protocols, such as, but not limited to, PCI Express, or can be a vendor specific communications interface or communications fabric. In one embodiment, the one or more parallel processor(s) 75 form a computationally focused parallel or vector processing system that can include a large number of processing cores and/or processing clusters, such as a many integrated core (MIC) processor. In one embodiment, the one or more parallel processor(s) 75 form a graphics processing subsystem that can output pixels to one of the one or more display device(s) 61 coupled via the I/O Hub 51. The one or more parallel processor(s) 75 can also include a display controller and display interface (not shown) to enable a direct connection to one or more display device(s) 63.

Within the I/O subsystem 50, a system storage unit 56 can connect to the I/O hub 51 to provide a storage mechanism for the computing system 500. An I/O switch 52 can be used to provide an interface mechanism to enable connections between the I/O hub 51 and other components, such as a network adapter 54 and/or a wireless network adapter 53 that can be integrated into the platform, and various other devices that can be added via one or more add-in device(s) 55. The network adapter 54 can be an Ethernet adapter or another wired network adapter. The wireless network adapter 53 can include one or more of a Wi-Fi, Bluetooth, near field communication (NFC), or other network device that includes one or more wireless radios.

The computing system 500 can include other components not shown in FIG. 5, including other port connections, optical storage drives, video capture devices, and the like, that can also be connected to the I/O hub 51. Communication paths interconnecting the various components in FIG. 5 can be implemented using any suitable protocols, such as PCI (Peripheral Component Interconnect) based protocols (e.g., PCI-Express), or any other bus or point-to-point communication interfaces and/or protocol(s), such as the NV-Link high-speed interconnect, or interconnect protocols known in the art.

In one embodiment, the one or more parallel processor(s) 75 incorporate circuitry optimized for graphics and video processing, including, for example, video output circuitry, and constitutes a graphics processing unit (GPU). In another embodiment, the one or more parallel processor(s) 75 incorporate circuitry optimized for general purpose processing, while preserving the underlying computational architecture. In yet another embodiment, components of the computing system 500 can be integrated with one or more other system elements on a single integrated circuit. For example, the one or more parallel processor(s) 75, memory hub 71, processor(s) 74, and I/O hub 51 can be integrated into a system on chip (SoC) integrated circuit. Alternatively, the components of the computing system 500 can be integrated into a single package to form a system in package (SIP) configuration. In one embodiment, at least a portion of the components of the computing system 500 can be integrated into a multi-chip module (MCM), which can be interconnected with other multi-chip modules into a modular computing system.

The computing system 500 shown herein is illustrative. Other variations and modifications are also possible. The connection topology, including the number and arrangement of bridges, the number of processor(s) 74, and the number of parallel processor(s) 75, can be modified as desired. For instance, in some embodiments, system memory 72 is connected to the processor(s) 74 directly rather than through a bridge, while other devices communicate with system memory 72 via the memory hub 71 and the processor(s) 74. In other alternative topologies, the parallel processor(s) 75 are connected to the I/O hub 51 or directly to one of the one or more processor(s) 74, rather than to the memory hub 71. In other embodiments, the I/O hub 51 and memory hub 71 can be integrated into a single chip. Some embodiments can include two or more sets of processor(s) 74 attached via multiple sockets, which can couple with two or more instances of the parallel processor(s) 75.

Some of the particular components shown herein are optional and may not be included in all implementations of the computing system 500. For example, any number of add-in cards or peripherals can be supported, or some components can be eliminated. Furthermore, some architectures can use different terminology for components similar to those illustrated in FIG. 5. For example, the memory hub 71 can be referred to as a Northbridge in some architectures, while the I/O hub 51 can be referred to as a Southbridge.

Further examples are now described. Example 1 is an active interconnection device comprising: a first repeater circuit comprising a first storage circuit, wherein the first storage circuit is coupled to store a first configuration bit for configuring the first repeater circuit to transmit a first signal.

In Example 2, the active interconnection device of Example 1 can optionally include, wherein the repeater circuit further comprises: a buffer circuit; and a first conductor coupled to the first storage circuit and to the buffer circuit.

In Example 3, the active interconnection device of Example 2 can optionally include, wherein the first storage circuit is coupled to receive the first configuration bit through the first conductor during a configuration mode, and wherein the buffer circuit is configurable to transmit the first signal through the first conductor during a transmission mode in response to the first configuration bit.

In Example 4, the active interconnection device of any one of Examples 1-3 further comprises: a second repeater circuit comprising a second storage circuit coupled to store a second configuration bit for configuring the second repeater circuit to transmit a second signal.

In Example 5, the active interconnection device of Example 4 can optionally include, wherein the second repeater circuit is configurable to transmit the second signal through a conductor, and wherein the second storage circuit is coupled to receive the second configuration bit through the conductor.

In Example 6, the active interconnection device of any one of Examples 1-5 can optionally include, wherein the first repeater circuit further comprises a first buffer circuit coupled to transmit the first signal in a first direction and a second buffer circuit coupled to transmit the first signal in a second direction, and wherein the first and the second buffer circuits are configurable by the first configuration bit stored in the first storage circuit.

In Example 7, the active interconnection device of any one of Examples 1-6 can optionally include, wherein the first repeater circuit further comprises a first buffer circuit and a first logic gate circuit coupled to provide a first value of the first configuration bit from the first storage circuit to the first buffer circuit to configure the first buffer circuit in a transmission mode.

In Example 8, the active interconnection device of Example 7 can optionally include, wherein the first repeater circuit further comprises a second buffer circuit and a second logic gate circuit coupled to provide an inverted value of the first configuration bit from the first storage circuit to the second buffer circuit to configure the second buffer circuit in the transmission mode.

In Example 9, the active interconnection device of any one of Examples 1-8 can optionally include, wherein the active interconnection device is one of a bridge or an interposer for coupling two integrated circuits.

Example 10 is a method for configuring an interconnection device, the method comprising: receiving a first configuration bit from a first input of the interconnection device at a first storage circuit in the interconnection device; configuring a first buffer circuit in the interconnection device for transmission based on the first configuration bit; and transmitting a first signal through the first input and the first buffer circuit during a transmission mode.

In Example 11, the method of Example 10 further comprises: receiving a second configuration bit from a second input of the interconnection device at a second storage circuit in the interconnection device.

In Example 12, the method of Example 11 further comprises: configuring a second buffer circuit in the interconnection device for transmission based on the second configuration bit; and transmitting a second signal through the second input and the second buffer circuit during the transmission mode.

In Example 13, the method of any one of Examples 10-12 can optionally include, wherein configuring the first buffer circuit in the interconnection device for transmission further comprises configuring a second buffer circuit in the interconnection device for transmission of the first signal through the interconnection device based on the first configuration bit.

In Example 14, the method of any one of Examples 10-13 can optionally include, wherein transmitting the first signal through the first input and the first buffer circuit during the transmission mode further comprises transmitting the first signal from a first integrated circuit die through the first input and the first buffer circuit to a second integrated circuit die.

In Example 15, the method of any one of Examples 10-14 further comprises: blocking configuration of the first buffer circuit based on the first configuration bit using a logic gate circuit during a configuration mode, wherein configuring the first buffer circuit for transmission based on the first configuration bit occurs during the transmission mode.

Example 16 is a circuit system comprising: first and second integrated circuits; and a connection device comprising a first conductor, a first buffer circuit, and a first storage circuit, wherein the first storage circuit is coupled to receive a first configuration signal through the first conductor, and wherein the first conductor and the first buffer circuit are coupled for signal transmission between the first integrated circuit and the second integrated circuit.

In Example 17, the circuit system of Example 16 can optionally include, wherein the first buffer circuit is coupled to be configured based on a value of the first configuration signal stored in the first storage circuit.

In Example 18, the circuit system of any one of Examples 16-17 can optionally include, wherein the connection device further comprises a second conductor, a second buffer circuit, and a second storage circuit, wherein the second storage circuit is coupled to receive a second configuration signal through the second conductor, wherein the second conductor and the second buffer circuit are coupled for signal transmission between the first integrated circuit and the second integrated circuit, and wherein the second buffer circuit is coupled to be configured based on a value of the second configuration signal stored in the second storage circuit.

In Example 19, the circuit system of any one of Examples 16-18 can optionally include, wherein the connection device is coupled to the first and the second integrated circuits.

In Example 20, the circuit system of any one of Examples 16-19 can optionally include, wherein the connection device further comprises a logic gate circuit coupled between a control input of the first buffer circuit and an output of the first storage circuit.

The foregoing description of the exemplary embodiments has been presented for the purpose of illustration. The foregoing description is not intended to be exhaustive or to be limiting to the examples disclosed herein. The foregoing is merely illustrative of the principles of this disclosure and various modifications can be made by those skilled in the art. The foregoing embodiments may be implemented individually or in any combination.

## Claims

1. An active interconnection device comprising:
a first repeater circuit comprising a first storage circuit,
wherein the first storage circuit is coupled to store a first configuration bit for configuring the first repeater circuit to transmit a first signal, wherein the active interconnection device is one of an interconnection bridge or an interposer.

2. The active interconnection device of claim 1, wherein the repeater circuit further comprises:
a buffer circuit; and
a conductor coupled to the first storage circuit and to the buffer circuit.

3. The active interconnection device of claim 2, wherein the first storage circuit is coupled to receive the first configuration bit through the conductor during a configuration mode, and wherein the buffer circuit is configurable to transmit the first signal through the conductor during a transmission mode in response to the first configuration bit.

4. The active interconnection device of any one of claims 1-3 further comprising:
a second repeater circuit comprising a second storage circuit coupled to store a second configuration bit for configuring the second repeater circuit to transmit a second signal.

5. The active interconnection device of claim 4, wherein the second repeater circuit is configurable to transmit the second signal through a conductor, and wherein the second storage circuit is coupled to receive the second configuration bit through the conductor.

6. The active interconnection device of any one of claims 1-5, wherein the first repeater circuit further comprises a first buffer circuit coupled to transmit the first signal in a first direction and a second buffer circuit coupled to transmit the first signal in a second direction, and wherein the first and the second buffer circuits are configurable by the first configuration bit stored in the first storage circuit.

7. The active interconnection device of any one of claims 1-6, wherein the first repeater circuit further comprises a first buffer circuit and a first logic gate circuit coupled to provide a first value of the first configuration bit from the first storage circuit to the first buffer circuit to configure the first buffer circuit in a transmission mode.

8. The active interconnection device of claim 7, wherein the first repeater circuit further comprises a second buffer circuit and a second logic gate circuit coupled to provide an inverted value of the first configuration bit from the first storage circuit to the second buffer circuit to configure the second buffer circuit in the transmission mode.

9. The active interconnection device of any one of claims 1-8, wherein the active interconnection device couples together two integrated circuits.

10. A method for configuring an interconnection device, the method comprising:
receiving a first configuration bit from a first input of the interconnection device at a first storage circuit in the interconnection device;
configuring a first buffer circuit in the interconnection device for transmission based on the first configuration bit; and
transmitting a first signal through the first input and the first buffer circuit during a transmission mode.

11. The method of claim 10 further comprising:
receiving a second configuration bit from a second input of the interconnection device at a second storage circuit in the interconnection device.

12. The method of claim 11 further comprising:
configuring a second buffer circuit in the interconnection device for transmission based on the second configuration bit; and
transmitting a second signal through the second input and the second buffer circuit during the transmission mode.

13. The method of any one of claims 10-12, wherein configuring the first buffer circuit in the interconnection device for transmission further comprises configuring a second buffer circuit in the interconnection device for transmission of the first signal through the interconnection device based on the first configuration bit.

14. The method of any one of claims 10-13, wherein transmitting the first signal through the first input and the first buffer circuit during the transmission mode further comprises transmitting the first signal from a first integrated circuit die through the first input and the first buffer circuit to a second integrated circuit die.

15. The method of any one of claims 10-14 further comprising:
blocking configuration of the first buffer circuit based on the first configuration bit using a logic gate circuit during a configuration mode, wherein configuring the first buffer circuit for transmission based on the first configuration bit occurs during the transmission mode.
